# EUROPÄISCHE PATENTSCHRIFT

(11) **EP 1 650 590 B1**
(45) Veröffentlichungstag und Bekanntmachung des Hinweises auf die Patenterteilung: **05.03.2008**
(21) Anmeldenummer: 05090283.2
(22) Anmeldetag: 11.10.2005
(51) Int. Cl.: G02B 7/182

(54) **Justiervorrichtung zur hochgenauen Positionierung eines Objekts**
Adjusting means for high-precision positioning of an object
Dispositif d'ajustement destiné au positionnement très précis d'un objet

(30) Priorität: 24.10.2004 DE 102004052155
(43) Veröffentlichungstag der Anmeldung: 26.04.2006
(73) Patentinhaber: Berliner Elektronenspeicherring-Gesellschaft für Synchrotronstrahlung mbH, 12489 Berlin (DE)
(72) Erfinder: Noll, Tino, 12524 Berlin (DE); Lammert, Heiner, 15831 Mahlow (DE)
(74) Vertreter: Rudolph, Margit

(56) Entgegenhaltungen:
- EP-A- 0 665 389
- DE-A1- 10 051 706
- US-A- 3 824 000
- US-A- 4 750 486
- US-A- 5 734 516

## Beschreibung

Die Erfindung bezieht sich auf eine Justiervorrichtung zur hochgenauen Positionierung eines Objekts gegenüber einer Basis mittels zumindest eines mit dem Objekt fest verbundenen Festkörpergelenks, das in seiner Auslenkung gegenüber der Basis mittels eines Antriebs einstellbar ist.

### Stand der Technik

Hauptanwendungsgebiet derartiger Justiervorrichtungen mit einer Justiergenauigkeit im µm-Bereich bis in den nm-Bereich sind einfache Justierungen im Gerätebau und im Maschinenbau, aber auch Linearversteller und kinematische Lagerungen bis hin zu Parallelkinematiken. In vielen Anwendungen sind Objekte, beispielsweise optische Elemente wie Linsen in der Halbleiterlithographie oder Spiegel in optischen Strahlengängen, hochgenau zu positionieren. Dabei verfügen diese Objekte über eine laterale Freiheit, können also seitlich frei verschoben werden. Im Allgemeinen wird eine Feinjustierung, also eine Justierung bis in den nm-Bereich, durch eine Justierschraube mit einem Kugelkopf realisiert, die auf eine präzise bearbeitete Planfläche drückt. Zumeist werden Federn verwendet, um die beiden Flächen aneinander zu drücken und ein Abheben zu verhindern. Weitere Justiervorrichtungen umfassen Linearversteller mit ebenfalls kugelförmigen Köpfen oder feste Zug-Druck-Verbindungen mit Gelenken, beispielsweise Verbindungsstäben, deren Länge einstellbar ist bzw. deren Lagerpunkte longitudinal verschiebbar sind.

Bei einer herkömmlichen Justierschraube, wie sie beispielsweise aus der US 2003/0133166 A1 bekannt ist, ist die Kontaktstelle zum Objekt als Kugellager ausgebildet. Das Kugel-Planfläche-Prinzip hat aber den gravierenden Nachteil, dass die Kugel die Oberfläche der zugeordneten Planfläche reibend abfährt. Die Rotationsentkopplung erfolgt somit durch Gleitreibung in der punktförmigen Kontaktfläche. Durch diese Reibung ist jedoch keine feinfühlige Verstellung in besonders kleinen Schritten, also unter 1 µm, möglich. Es wird vielmehr die Ebenheit der Planfläche des Objekts auf dessen Justierungsposition abgebildet.

Aus der DE 296 18 149 U1 ist eine Sechsachsenverstelleinrichtung bekannt, bei der das Objekt über sechs gelenkige und jeweils von einem Linearantrieb angetriebene Koppelelemente an die Basis gekoppelt ist, wobei die Linearantriebe an der Basis angeordnet sind. Die Ankopplung der Koppelelemente an das Objekt erfolgt auch hier über Kugellagerungen. In einer Ausführungsform zur Beseitigung von Spiel in der Justierung ist vorgesehen, dass das Objekt gegenüber der Basis über Federn verspannt ist und die Koppelelemente als reine Zugelemente in Form von Drähten ausgebildet sind. Die rotatorische Entkopplung der Koppelelemente vom Objekt erfolgt jedoch auch hier über Kugelgelenke, sodass die oben beschriebenen Nachteile dieser reibungsbehafteten Justierung bestehen bleiben.

Aus der DE 100 51 706 A1 ist eine Vorrichtung zur hochgenauen Positionierung eines optischen Elementes bekannt, von der die vorliegende Erfindung als nächstliegendem Stand der Technik ausgeht. Das optische Element ist in einer Innenfassung gelagert, die über drei in einer Ebene gelagerte Festkörpergelenke mit einer Außenfassung fest verbunden ist. Die Innenfassung ist somit das zu verstellende Objekt. Innenfassung, Festkörpergelenke und Außenfassung sind einstückig aufgebaut, sodass die Festkörpergelenke zumindest mit der Innenfassung fest verbunden sind und reibungsbegründete Positionierungenauigkeiten wie bei kugelgelagerten Verbindungen nicht auftreten können. Die Verstellwege werden vielmehr von den Festkörpergelenken bzw. deren flexiblen Gelenkstellen durch Deformation aufgenommen. Die flexiblen Gelenkstellen an beiden Enden des Festkörpergelenks werden durch Einschnitte im Verbund erzeugt, sodass das Festkörpergelenk einen T-förmigen Querschnitt aufweist. Dabei sind die Verbindungsstege jedoch relativ breit dimensioniert. Die Festkörpergelenke sind am Umfang der Innenfassung gleichmäßig verteilt und werden durch linear wirkende Manipulatoren ausgelenkt, die an der T-Stütze der Festkörpergelenke angreifen. Die Justierung der Linse kann nur durch Kippen oder Heben und Senken der Innenfassung über eine Verstellung der Festkörpergelenke erfolgen. Durch den geschlossenen Aufbau der Linse in der Innenfassung, die in der Außenfassung geführt ist, ist jedoch keine seitliche Verschiebung der Linse möglich. Diese kann jedoch bei Verschiebungen in andere Richtungen durch Verkippen der Linse auftreten. Somit besteht keine laterale Freiheit für die Linse und es kann zu Verklemmungen bei der Justierung kommen. Weiterhin ist das Festkörpergelenk T-förmig ausgebildet und damit relativ massiv in seinen Abmessungen. Der Antrieb wirkt auf die T-Stütze des Festkörpergelenks und ruft hier bereits eine Deformation hervor. Diese kann nur ungenau auf den T-Balken des Festkörpergelenks und anschließend über die relativ breite Verbindung auf die Innenfassung übertragen werden, sodass sich durch diesen Aufbau Schwankungen in der Positioniergenauigkeit durch auftretendes Spiel und Hysterese ergeben können. Weiterhin ist die Positioniergenauigkeit von der Festigkeit der Anbindung des Festkörpergelenks an das Objekt abhängig. Ist diese sehr weich, so werden Positionsabweichungen aufgrund der Schwerkraft des Objekts hervorgerufen, die die Festkörpergelenke belastet und eindrückt oder deformiert. Auch durch diesen Umstand können Spiel- und Hystereseeffekte auftreten. Insgesamt ist die Positioniergenauigkeit bei der bekannten Justiervorrichtung damit nur schwer im Voraus berechenbar und wird vielmehr durch eine Ausregelung über integrierte Stellungsdetektoren erreicht.

### Aufgabenstellung

Die **Aufgabe** für eine Justiervorrichtung zur hochgenauen Positionierung eines Objekts der eingangs beschriebenen Art ist daher darin zu sehen, diese so weiterzubilden, dass Justierungen reibungsfrei mit höchster Präzision bis in den nm-Bereich vorgenommen werden, wobei keine spiel- und hysteresebedingten Ungenauigkeiten auftreten sollen. Dabei sollen einfache Mittel eingesetzt und aufwändige Regelkreise und Verklemmungen aufgrund auftretender lateraler Beschränkungen vermieden werden. Die erfindungsgemäße **Lösung** für diese Aufgabe ist dem Hauptanspruch zu entnehmen. Vorteilhafte Weiterbildungen der Erfindung sind den Unteransprüchen zu entnehmen, die im Folgenden im Zusammenhang mit der Erfindung näher erläutert werden.

Die erfindungsgemäße Justiervorrichtung weist als Festkörpergelenk zumindest ein Fadenjustierelement mit einem verdrehfähigen Faden mit einer hohen Biege- und Torsionsflexibilität auf, der mit dem Objekt fest verbunden und diesem gegenüber durch ein Spannelement vorgespannt ist. Die Verbindung zwischen dem Objekt und der Basis zur Vornahme von Positionierungen wird somit durch einen eindimensionalen Faden hergestellt. An die Stelle der herkömmlichen Kugelfläche, die auf eine Planfläche drückt, oder der breit dimensionierten einstückigen Verbindung zum Objekt tritt eine punktförmige Verbindung, die in sich keine Reibung und Deformationen zulässt, sodass die Verstellwege hochpräzise spiel- und hysteresefrei auf das Objekt übertragen werden können. Ein Faden übernimmt dabei sämtliche Gelenkfunktionen einschließlich der Rotationsentkopplung. Bei dem Fadenprinzip wird somit der Einfluss von Fertigungstoleranzen auf die Genauigkeit der Justierbarkeit stark zurückgedrängt und auf der Fähigkeit eines Fadens aufgebaut, Verdrehungen/Verwindungen aufnehmen zu können. Der durch die freie Länge des Fadens festgelegte Abstand zwischen dem Objekt und der Basis ist dabei so groß, dass sich eine relativ große laterale Freiheit des Objekts ergibt und ein Verkanten bei der Verstellung verhindert wird. Da die freie Länge und die relative Lage des Fadens im Raum die Raumposition des Objekts festlegen, führen sowohl ein Verschieben des Befestigungspunktes des Fadens an seinem linearen Antrieb als auch eine Veränderung der freien Fadenlänge zu einer longitudinalen Ortsveränderung in Richtung der Fadenachse. Bei dieser longitudinalen Auslenkung des Objekts werden die Fäden weiterer vorgesehener Fadenjustierelemente (siehe auch weiter unten) reibungsfrei verkippt. Der dabei entstehende parasitäre Hub der Fäden stellt selbst bei präzisen Justierungen im Nanometerbereich kein Problem dar, da die Größe dieses parasitären Hubes bei geeigneter Proportionierung der Längenverhältnisse um mindestens eine Größenordnung kleiner ist als der eingestellte Justierhub als Hauptbewegung. Dadurch ist es einfach möglich, auch mehrachsige Systeme iterativ, also durch die aufeinander folgende Verstellung mehrerer Fadenjustierelemente mit Fadenprinzip in den einzelnen Achsrichtungen zu justieren.

Die erfindungsgemäße Justiervorrichtung mit Fadenjustierelementen nach dem Fadenprinzip basiert auf einer Vorspannung zwischen dem Objekt und der Basis, die durch eine Fadenverlagerung und/oder Fadenverkürzung noch vergrößert und durch eine Fadenverlagerung und/oder Fadenverlängerung verkleinert werden kann. Dabei kann diese Vorspannkraft beispielsweise durch Gewichtskräfte, Magnete oder eine geschlossene Fadenführung erzeugt werden. Eine besonders einfache Methode stellt das Aufbringen einer Vorspannkraft in geeigneter Höhe über ein Spannelement dar. Dabei können bevorzugt zwei Ausführungsformen zur Anwendung kommen. Zum einen kann ein einzelnes Spannelement zentral zwischen dem Objekt und der Basis angeordnet, zum anderen kann jedem Fadenjustierelement ein Spannelement zugeordnet sein. Ein zentrales Spannelement wird bevorzugt dann einzusetzen sein, wenn es die Platzverhältnisse am Objekt erfordern oder wenn mehrere Fadenjustierelemente auf ein Objekt zur mehrachsigen Verstellung gemeinsam einwirken. Insbesondere bei einem zentral gut zu lagernden Objekt, beispielsweise einem flachen Spiegel, kann das Spannelement unterhalb des Spiegels angeordnet sein und die Fäden jeweils in den kartesischen Achsen am Spiegel angreifen. Die Fadenjustierelemente selbst benötigen dann kein Spannelement mehr, im einfachsten Fall kann der Faden manuell verschoben, verlängert oder verkürzt und jeweils an der Basis festgelegt werden. Bei ungünstigen Platzverhältnissen oder einer einachsigen Longitudinalverschiebung kann jedes Fadenjustierelement ein ihm zugeordnetes Spannelement aufweisen. Somit wird der Faden des Fadenjustierelements, das fest mit der Basis verbunden ist, direkt gegenüber dem Objekt verspannt. Insbesondere kann dabei der Faden parallel zu dem auf Druck ausgelegten Spannelement oder in Reihe zu dem auf Zug ausgelegten Spannelement angeordnet sein. Eine Parallelschaltung ist besonders Platz sparend. Bei einer Ausbildung des Spannelements als Spiralfeder beispielsweise kann der Faden im Innern der als Druckfeder ausgelegten Spiralfeder verlaufen. Bei einer auf Zug ausgelegten Spannfeder liegt diese mit dem Faden in Reihe, insbesondere kann sie unter 180° zum Faden auf das Objekt einwirken. Bei besonders lang konzipierten Fadenjustierelementen zur Überbrückung größerer Abstände zwischen Objekt und Basis und auch aus Genauigkeitsgründen kann die Spiralfeder in ihrem Mittenbereich von einer Hülse umschlossen oder von dieser ersetzt sein, sodass ein Ausknicken der Spiralfeder sicher verhindert ist.

Zur Erhöhung der aufbringbaren Verstellkraft kann der Faden zwei- oder mehrfach umgelenkt in der Justiervorrichtung verlaufen, sodass sich eine Kraftübersetzung nach Art eines Flaschenzugs ergibt. Wie weiter oben schon ausgeführt, werden die Verstellbewegungen reibungs- und spielfrei sowie rotationsentkoppelt von dem Faden auf das Objekt übertragen. Dazu ist es vorteilhaft, wenn der Faden stoff- oder formschlüssig mit dem Objekt verbunden ist. Eine stoffschlüssige Verbindung kann beispielsweise durch Verkleben des Fadens in einer Bohrung im Objekt selbst oder in einem Träger des Objekts erfolgen. Eine formschlüssige Verbindung entsteht beispielsweise, wenn der Faden durch das Objekt oder seinen Träger in einer Bohrung hindurch gezogen und verknotet wird. Der Knoten kann dann auf dem Objekt aufliegen oder in einer größeren Bohrung versenkt sein. Die Justiervorrichtung nach der Erfindung basiert wesentlich auf der Fähigkeit eines aus einer Vielzahl von Einzelfasern bestehenden Fadens (unter den Begriff "Faden" sollen im Sinne der Erfindung auch die Begriffe "Seil" mit geschlagenen bzw. gedrehten Einzelfasern und "Kordel" mit geflochtenen Einzelfasern verstanden sein), eine Verdrehung oder eine Verwindung reibungsfrei aufzunehmen und somit eine drehelastische Verbindung darzustellen. Dabei kann der Faden beispielsweise als Stahlseil oder -litze, Kunststoffschnur oder als geflochtene Kunststoffkordel ausgebildet sein. Dabei kann es sich bei dem Kunststoff beispielsweise um eine Aramidfaser (Kevlarfaser) oder um eine synthetische Polyamidfaser (Nylonfaser) handeln. Ein Stahlseil besteht aus mehreren um eine Einlage gedrehte Litzen, wobei jede Litze aus einem Mittendraht besteht, um den wiederum mehrere Drähte gewunden sind. Geflochtene Fäden haben den besonderen Vorteil, dass sie sich nicht aufwickeln, wenn sie verdrillt werden. Weiterhin zeigen sie Ermüdungserscheinungen durch eine Überbeanspruchung des Fadenjustierelements durch Reißen einzelner Fasern an, sodass Wartungsmaßnahmen sofort unter Vermeidung größerer Schäden eingeleitet werden können. In der Regel werden mit der Justiervorrichtung Verstellwege bis in den nm-Bereich ausgeführt werden. Es kann also von kleinsten Verdrehungen des Fadens ausgegangen werden, die günstigstenfalls alternativ durchgeführt werden, sodass sie sich gegenseitig aufheben. Im Falle größerer Verdrehungen, die unter Umständen alle in die gleiche Richtung ausgeführt werden, ist es dagegen vorteilhaft, wenn in Reihe zum Fadenjustierelement ein feststellbares oder reibungsbehaftetes Axiallager vorgesehen ist, mit dem eine Torsionsentlastung des Fadens im Anschluss an dessen Grobverstellung ausgeführt werden kann.

Die Justierbewegung zur Einstellung der Fadenlage oder freien Fadenlänge kann durch jedes Element ausgeführt werden, das einen linearen Hub hervorruft. Dabei kann der lineare Antrieb beispielsweise als manuell zu verstellende Justierschraube oder Stimmwirbel ausgebildet sein. Die Justierschraube kann in ihrer Mitte eine Bohrung aufweisen, durch die der Faden geführt wird. Die Festlegung des Fadens kann in einer Klemmschraube am Ende der Justierschraube erfolgen. Bei der Verwendung eines Stimmwirbels kann ein Schneckengetriebe wie bei einer Gitarre vorgesehen sein. Weiterhin kann eine Reibhemmung wie bei einer Geige vorgesehen sein; um ein Lösen des verkürzten Fadens zu verhindern. Weiterhin kann der Antrieb als thermisch längenänderbares System ausgebildet sein. Durch die temperaturabhängige Längenänderung eines beispielsweise massiven Metallstabes können sehr genaue Verstellwege hysteresefrei eingestellt werden. Anstelle des Einsatzes eines zusätzlichen Stellelements ist es aber auch möglich, den Stellhub durch eine direkte Erwärmung oder Abkühlung des Fadens selbst zu erreichen. Weiterhin können Antriebe eingesetzt werden, die Verstellelemente aufweisen, die piezoelektrisch oder motorisch angetrieben werden. Der Faden kann auch unterbrochen sein, um seine Gesamtlänge beispielsweise durch einen Piezostapeltranslator zu ändern. Dabei können Grob- und Feinstellantriebe kombiniert werden, in dem beispielsweise eine Justierschraube an der Basis die Grobposition einstellt und der Piezostapeltranslator die Feinposition. Piezostapeltranslatoren eignen sich hier auch ganz besonders für schnelle Positionsreglungen, da sie einige hundert Mal pro Sekunde nachgestellt werden können. Wird als motorisches Antriebssystem ein Linearmotor verwendet, können ebenfalls kleinste Verstellwege hochgenau und hysteresefrei sowie auch automatisiert eingestellt werden.

Weiter oben wurde bereits ausgeführt, dass je nach Anwendungsfall ein oder mehrere Fadenjustierelemente an einem Objekt angreifen können. Um eine Justiereinrichtung nach Vorbild des Hexapods zu erhalten, können mehrere Fadenjustierelemente auf den Achsen des kartesischen Koordinatensystems angeordnet sein, dabei können insbesondere mehrere Fadenjustierelemente parallel zu einer Achse des kartesischen Koordinatensystems angeordnet sein. Beim Sechsstablager sind sechs Fadenjustierelemente (je zwei in Richtung einer kartesischen Achse) erforderlich, um das Objekt in allen Raumrichtungen mit sechs Freiheitsgraden (drei translatorische, drei rotatorische) hochpräzise justieren zu können. Auch bei einer Mehrfachanordnung von Fadenjustierelementen in der Justiervorrichtung kann jedes Fadenjustierelement seinen eigenen Antrieb aufweisen. Vorteilhaft kann es aber auch sein, wenn die Fäden mehrerer Fadenjustierelemente mittels eines gemeinsamen Antriebs verlängert oder verkürzt werden, sodass ein Abgleich in der Verstellaenauigkeit zwischen den verschiedenen Antrieben nicht erforderlich ist. Dabei kann der gemeinsame Antrieb einen Justierstock oder eine Wickeltrommel aufweisen. Bei einem Justierstock werden mehrere Fäden gleichzeitig nach Art einer Marionettenführung bewegt. Auf diese Weise können Translationen und Rotationen mit einem gemeinsamen Verstellknopf angetrieben werden. Bei längeren Fäden ist ein Aufwickeln auf eine Trommel sehr vorteilhaft. Damit dabei aber nicht der untere Gelenkpunkt (zwischen Fadenjustierelement und Basis bzw. Antrieb im Gegensatz zum oberen Gelenkpunkt zwischen Fadenjustierelement und Objekt) verschoben wird, kann ein Bundsteg, wie beispielsweise bei einer Gitarre oder einem Klavier, verwendet werden, über den die Fäden auf die Wickeltrommel umgeleitet werden. Alternativ kann jeder Faden auch durch eine Düse hindurchgeführt sein. Deren Austrittsöffnung definiert dann den unteren Gelenkpunkt zur Basis. Eine weitere Alternative ist auch das Führen des Fadens über eine Umlenkrolle, deren Ablauffläche dann den unteren Gelenkpunkt definiert. Die Umlenkrolle ist ortsfest angeordnet und kann in ihrer Anordnung an die örtlichen Gegebenheiten im Umfeld des zu verstellenden Objekts angepasst sein. Sie ermöglicht eine parallele Anordnung einer Vielzahl von Fäden, dabei vermeidet sie eine scharfe Umlenkung der Fäden, wodurch keine Abnutzungserscheinungen bei einer häufigen Längenänderung der Fäden auftreten können. Andererseits können ausreichend große Umlenkwinkel erreicht und so ein Abheben des Fadens von der Umlenkrolle beim Verstellen vermieden werden.

### Ausführungsbeispiele

**Ausbildungsformen** der Justiervorrichtung nach der Erfindung werden zu deren weiterem Verständnis nachfolgend anhand der schematischen Figuren näher erläutert. Dabei zeigt:
- **Figur 1**: ein Fadenjustierelement mit einer Druckfeder,
- **Figur 2**: ein Fadenjustierelement mit einer Zugfeder,
- **Figur 3**: eine Justiervorrichtung mit drei Freiheitsgraden,
- **Figur 4**: eine Justiervorrichtung mit zwei Freiheitsgraden,
- **Figur 5**: eine Justiervorrichtung mit einer zentralen Druckfeder und

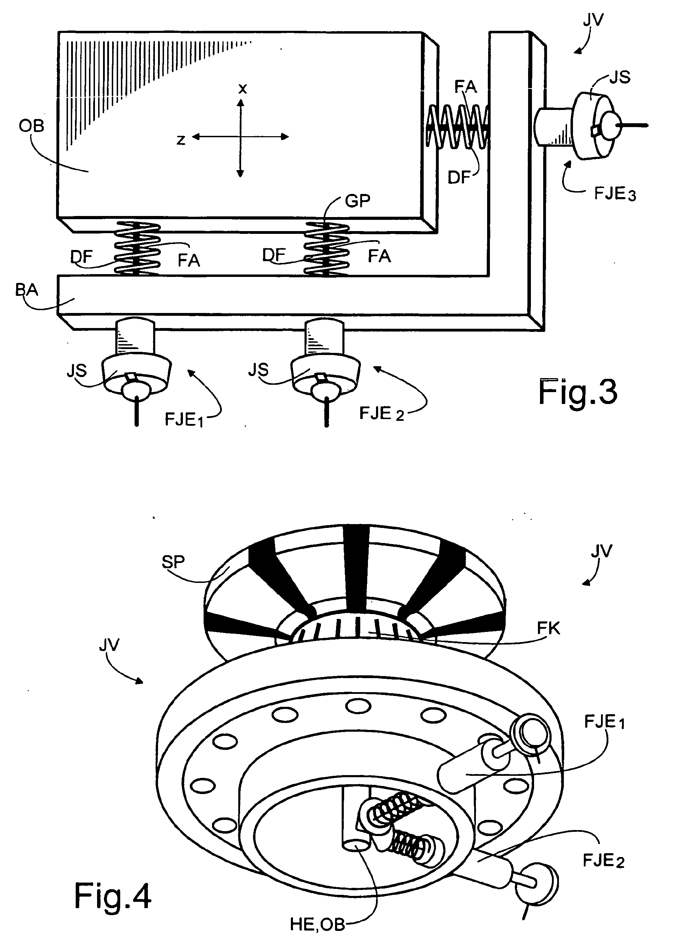

- **Figur 4**: eine Justiervorrichtung mit sechs Freiheitsgraden.

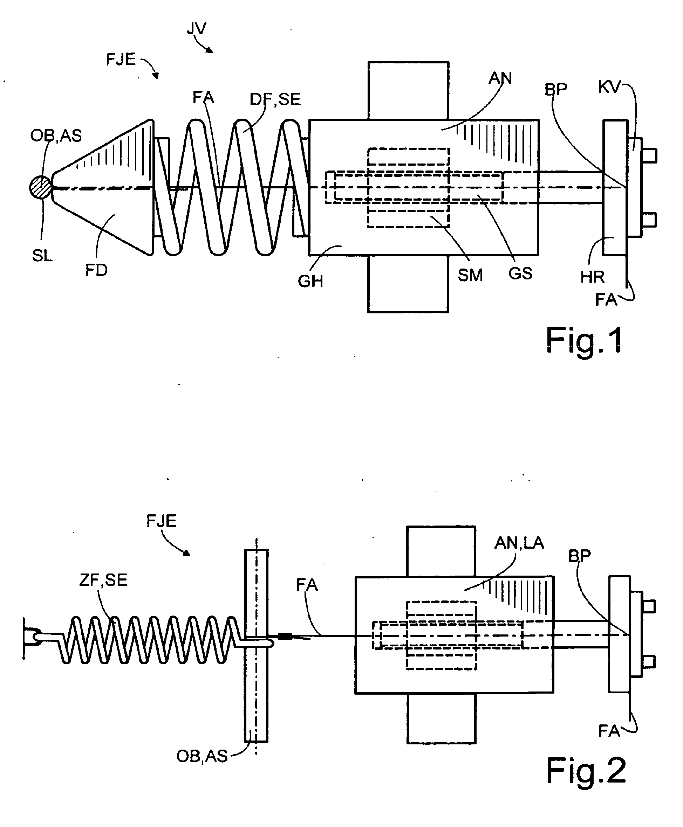

Die **Figur 1** zeigt ein Fadenjustierelement **FJE** mit einem verdrehfähigen Faden **FA** und einer spiraligen Druckfeder **DF** als Spannelement **SE.** Der Faden bildet an seinem vorderen Ende eine Schlaufe **SL,** die um das zu verstellende Objekt **OB,** hier eine einfache Achse **AS,** gelegt werden kann. Die Druckfeder **DF** stützt sich zwischen einer Fadendüse **FD** und einem Gehäuse **GH** als Teil des Antriebs **AN** ab. Die Fadendüse **FD** drückt im Einsatzfall gegen das zu verstellende Objekt **OB** und die Druckfeder **DF** baut zwischen diesem und der Basis **BA** eine Vorspannung auf. Dadurch wird der Faden **FA,** der im Innern der Druckfeder **DF** parallel zu dieser verläuft, immer straff gehalten. Im Innern weist das mit der Basis **BA** fest verbundene Gehäuse **GH** eine ebenfalls mit dem Gehäuse **GH** fest verbundene Spindelmutter **SM** auf, in der eine Gewindespindel **GS** läuft. Am hinteren Ende tritt die Gewindespindel **GS** aus dem Gehäuse **GH** aus und endet in einem Handrad **HR** mit einer Klemmvorrichtung **KV,** in der der Faden **FA** in einem Befestigungspunkt **BP** festgelegt ist. Die freie Fadenlänge bzw. die Fadenposition wird durch die Position der Spindelmutter **SM** auf der Gewindespindel **GS** und damit durch die Position des Befestigungspunktes **BP** festgelegt. Durch Drehen des Handrades **HR** und damit der Gewindespindel **GS** kann diese Position und damit die freie Fadenlänge manuell verändert werden. Mit einer Justiervorrichtung **JV** auf Basis des gezeigten Fadenjustierelements **FJE** kann hochpräzise, reibungs- und hysteresefrei eine longitudinale Verstellung, beispielsweise entlang der x-Achse des kartesischen Koordinatensystems, bis in den nm-Bereich erreicht werden.

In der **Figur 2** ist ein Fadenjustierelement **FJE** mit einem verdrehfähigen Faden **FA** und einer spiraligen Zugfeder **ZF** als Spannelement **SE** dargestellt. Zugfeder **ZF** und Faden **FA** sind in Reihe zueinander geschaltet und liegen einander bezüglich des zu verstellenden Objekts **OB,** hier wieder eine Achse **AS,** diametral gegenüber. In diesem Ausführungsbeispiel ist ein elektrischer Antrieb **AN,** hier ein Linearantrieb **LA,** zur Verstellung gezeigt. Hier nicht weiter erläuterte Bezugszeichen sind der **Figur 1** zu entnehmen.

Die **Figur 3** zeigt eine einfache Justiervorrichtung **JV** mit drei Fadenjustierelementen **FJE₁, FJE₂, FJE₃,** die an einem quaderförmigen Objekt **OB** angreifen. Die Justiervorrichtung **JV** weist eine Basis **BA** in Form eines stabilen Winkels auf, gegenüber dem sich die drei Druckfedern **DF** der Fadenjustierelemente **FJE₁, FJE₂, FJE₃** zum Objekt **OB** hin abstützen. Die Fäden **FA** sind jeweils in das Objekt OB eingeklebt und durch Bohrungen in der Basis **BA** hindurchgeführt, wo sie mit einfachen Justierschrauben **JS** in ihrer Länge eingestellt und festgelegt werden. Zwei Fadenjustierelemente **FJE₁, FJE₂** liegen parallel zur x-Achse, ein Fadenjustierelement **FJE₃** parallel zur z-Achse. Dadurch erhält das Objekt **OB** drei Freiheitsgrade: Zwei translatorische in x- und z-Richtung und einen rotatorischen um die vertikale y-Achse. Zur Verschiebung in x-Richtung sind zwei Fadenjustierelemente **FJE₁, FJE₂ ,** zur Verschiebung in z-Richtung ist ein drittes Fadenjustierelement **FJE₃** zu verstellen. Eine Überlagerung der beiden Verstellwege unter Festhalten des unteren Fadenjustierelements **FJE₂** in x-Richtung ergibt eine Drehung des Objekts **OB** um einen reibungsfreien Gelenkpunkt **GP** dieses Fadenjustierelements **FJE₂** direkt am Objekt **OB.** Wird auch dieses Fadenjustierelement **FJE₂** verstellt, ergibt sich eine Überlagerung aus Rotation und Translation, sodass mit Hilfe der drei Fadenjustierelemente **FJE₁, FJE₂, FJE₃** alle winkligen Objektpositionen in der x-z-Ebene hochgenau und reproduzierbar eingestellt werden können. Hier nicht weiter erläuterte Bezugszeichen sind den vorhergehenden Figuren zu entnehmen.

In der **Figur 4** ist eine Justiervorrichtung **JV** dargestellt, bei der zwei Fadenjustierelemente **FJE₁, FJE₂** an einem Hebel **HE** als Objekt **OB** gemeinsam unter einem rechten Winkel angreifen. Somit kann der Hebel **HE** hochgenau und reproduzierbar in der x-z-Ebene eingestellt werden. Im gewählten Ausführungsbeispiel ist der Hebel **HE** mit dem oberen Rand eines Federkorbs **FK** verbunden. Über den Federkorb **FK** kann nach Art eines reibungs- und hysteresefreien Rotationslagers beispielsweise ein optischer Spiegel **SP** hochgenau in einem optischen Strahlengang positioniert werden. Hier nicht weiter erläuterte Bezugszeichen sind den vorhergehenden **Figuren** zu entnehmen. In ähnlicher Form können beispielsweise vier Fadenjustierelemente (je zwei rechtwinklig zueinander und je ein Paar in einer Ebene) beispielsweise auf eine horizontale Welle als Objekt angreifen. Es entsteht eine Lagerung nach der Art eines Doppellagerbocks. Da bei einer derartigen Ausführungsform die Druckfedern relativ lang sein können, können sie in ihrer Mitte Hülsen gegen Ausknicken aufweisen (in **Figur 4** nicht dargestellt).

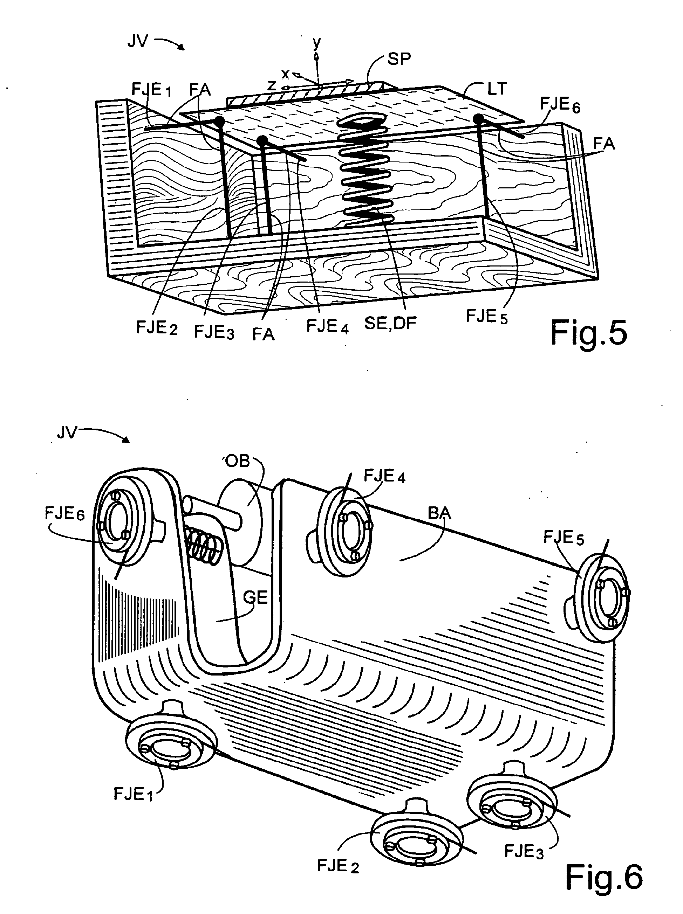

Die **Figur 5** zeigt eine Justiervorrichtung **JV** mit einem zentralen Spannelement **SE,** hier eine spiralige Druckfeder **DF.** Diese greift an einen Lagertisch **LT** an, auf dem beispielsweise ein Spiegel **SP** gelagert ist. Nach Art eines Sechsstablagers mit sechs Freiheitsgraden sind sechs kartesisch angeordnete Fadenjustierelemente **FJE₁, FJE₂, FJE₃, FJE₄, FJE₅, FJE₆** vorgesehen, die nurmehr aus den Fäden **FA** bestehen. Jeder Faden **FA** ist durch eine Bohrung in der Basis **BA** mit einer hier nicht dargestellten Justierschraube **JS** zur Längeneinstellung verbunden und festgelegt. Durch die kombinatorische Verstellung aller sechs Justierschrauben **JS** können drei translatorische und drei rotatorische Verstellungen in Überlagerung für den Spiegel **SP** eingestellt werden. Hier nicht weiter erläuterte Bezugszeichen sind den vorhergehenden **Figuren** zu entnehmen. In ähnlicher Anordnung können beispielsweise 12 Fadenjustierelemente, von denen jedoch jedes eine eigene Druckfeder aufweist, an einem Lagertisch angreifen, der reine Translationsbewegungen ausführen soll. Dabei bilden sechs Fadenjustierelemente gleichsam die Tischbeine, jeweils zwei parallele Fadenjustierelemente stützen den Lagertisch an seinen orthogonalen Tischkanten horizontal gegen die Basis ab. Bei einer derartigen Anordnung können die Fäden der sechs vertikalen Fadenjustierelemente ― insbesondere auch über Umlenkrollen - auf eine gemeinsame Wickeltrommel geführt sein, sodass durch Betätigung nur einer Stellschraube der Lagertisch einfach und gleichmäßig in seiner Höhe verstellt werden kann. Auch die vier horizontalen Fadenjustierelemente können jeweils über eine gemeinsame Trommel angetrieben werden, sodass auch seitliche Tischbewegungen gleichmäßig durchgeführt werden können (in den **Figuren** nicht dargestellt).

In der **Figur 6** ist schematisch ein Objekt **OB,** beispielsweise ein Polarimeter, gezeigt, das auf einem Gestell **GE** ruht, das wiederum gegenüber der Basis **BA** kartesisch gelagert ist. Dazu weist die gezeigte Justiervorrichtung **JV** wiederum sechs kartesisch angeordnete Fadenjustierelemente **FJE₁, FJE₂, FJE₃, FJE₄, FJE₅, FJE₆** auf, nunmehr jedoch gegenüber der **Figur 5** in einer anderen Anordnung. Auf der Unterseite der Basis **BA** sind drei Fadenjustierelemente **FJE₁, FJE₂, FJE₃,** auf der Rückseite zwei Fadenjustierelemente **FJE₄, FJE₅** und auf der Stirnseite ist ein Fadenjustierelement **FJE₆** angeordnet. Eine derartige Anordnung in Abwandlung eines Hexapods ist beispielsweise auch in der deutschen Patentschrift DE 100 42 802 C2 offenbart und hat den Vorteil, dass das Objekt **OB** in allen sechs Freiheitsgraden hochgenau und reproduzierbar mit einem minimalen Verstellaufwand von einzelnen Fadenjustierelementen **FJE₁, FJE₂, FJE₃, FJE₄, FJE₅, FJE₆** verstellt werden kann. Die Fadenjustierelemente können in die Funktion der auch elastisch ausführbaren Zweigelenkglieder aus der genannten Patentschrift eintreten, wenn die Vorspannung der Fäden so groß ist, dass die axialen Druckkräfte auf die Zweigelenkglieder sicher aufgenommen werden und der Faden sich nach außen wie ein Stab mit zwei elastischen Gelenken verhält. Der Vorteil der Fadenjustierelemente besteht dabei darin, dass die Fadenjustierungen zugleich die Funktion einer Verdrehentkopplung beinhalten, weil der Faden in seinen Materialeigenschaften viel leichter tordierbar ist als ein starrer Stab. Somit kann der Faden an einem der beiden Gelenkpunkte fest mit einer Justierschraube verbunden sein. Der Aufbau vereinfacht sich also und die Konstruktion kann leichter und kostengünstiger ausgeführt werden.
Ein zweiter wesentlicher Vorteil besteht in der einfachen Möglichkeit, die Verstellung mehrerer Zweigelenkglieder zu koppeln, in dem die Fäden zusammengefasst verstellt werden, beispielsweise durch Wickelstöcke, wie bereits beschrieben. Die Einzelverstellbarkeit eines Zweigelenkgliedes kann dabei jedoch erhalten bleiben, indem die Justierschraube nur zur Umlenkung des Fadens dient, oder die beschriebene Umlenkrolle justierbar ist. Somit ist es möglich, jede kartesische Bewegung des Objekts mit nur einem Stellknopf zu justieren. Wird also der Faden der Fadenjustierelemente **FJE₁, FJE₂, FJE₃** nicht an der Justierschraube **JS** fixiert, sondern nur durchgeführt und auf eine gemeinsame Wickeltrommel gewickelt, ist eine Translation in vertikaler Richtung allein durch Drehen der Wickeltrommel möglich. Ohne diese zu verstellen, kann aber an der Justierschraube **JS** des Fadenjustierelements **FJE₁** gedreht werden, um das Objekt **OB** aus der Ebene herauszukippen, also eine Verdrehung anzutreiben. Gleiches gilt für die Fadenjustierelemente **FJE₄** und **FJE₅.** Statt der sechs Justierschrauben **JS** könnten auch hier Umlenkrollen verwendet werden, die entlang der Wirkungslinie eines Fadenjustierelements **FJE** verschiebbar ist. Gegenüber der Patentschrift DE 100 42 802 C2 ergibt sich somit der gravierende Vorteil, dass auch für die Translation in y- und z-Richtung nur eine Verstellung erforderlich ist, ohne die einfachen Verstellungen für die Translation in x-Richtung sowie die drei Rotationen aufzugeben.

### Bezugszeichenliste

- **AS**: Achse
- **AN**: Antrieb
- **BA**: Basis
- **BP**: Befestigungspunkt
- **DF**: Druckfeder
- **FA**: Faden
- **FD**: Fadendüse
- **FK**: Federkorb
- **FJE**: Fadenjustierelement
- **GE**: Gestell
- **GH**: Gehäuse
- **GP**: Gelenkpunkt
- **GS**: Gewindespindel
- **HE**: Hebel
- **HR**: Handrad
- **JS**: Justierschraube
- **JV**: Justiervorrichtung
- **KV**: Klemmvorrichtung
- **LA**: Linearantrieb
- **LT**: Lagertisch
- **OB**: Objekt
- **SE**: Spannelement
- **SL**: Schlaufe
- **SM**: Spindelmutter
- **SP**: Spiegel
- **ZF**: Zugfeder

## Patentansprüche

1. Justiervorrichtung zur hochgenauen Positionierung eines Objekts gegenüber einer Basis mittels zumindest eines mit dem Objekt fest verbundenen Festkörpergelenks, das in seiner Auslenkung gegenüber der Basis mittels eines Antriebs einstellbar ist,
**dadurch gekennzeichnet, dass**
das Festkörpergelenk als Fadenjustierelement (FJE) ausgebildet ist und einen verdrehfähigen Faden (FA) aufweist, der mit dem Objekt (OB) fest verbunden und diesem gegenüber durch ein Spannelement (SE) vorgespannt ist, und eine longitudinale Auslenkung des Fadenjustierelements (FJE) durch ein Verschieben eines Befestigungspunktes (BP) des Fadens (FA) an einem mit der Basis (BA) fest verbundenen linearen Antrieb (AN) durch dessen Verstellung erfolgt, wobei die Verschiebung und die freie Länge des Fadens (FA) den Abstand zwischen dem Objekt (OB) und der Basis (BA) festlegt.

2. Justiervorrichtung nach Anspruch 1,
**dadurch gekennzeichnet, dass**
ein einzelnes Spannelement (SE) zentral zwischen dem Objekt (OB) und der Basis (BA) angeordnet ist.

3. Justiervorrichtung nach Anspruch 1,
**dadurch gekennzeichnet, dass**
jedem Fadenjustierelement (FJE) ein Spannelement (SE) zugeordnet ist und der Faden (FA) parallel zu dem auf Druck ausgelegten Spannelement (SE) oder in Reihe zu dem auf Zug ausgelegten Spannelement (SE) angeordnet ist.

4. Justiervorrichtung nach einem der Ansprüche 1 bis 3,
**dadurch gekennzeichnet, dass**
das Spannelement (SE) als Spiralfeder ausgebildet ist.

5. Justiervorrichtung nach Anspruch 4,
**dadurch gekennzeichnet, dass**
die Spiralfeder in ihrem Mittenbereich von einer Hülse umschlossen oder von dieser ersetzt ist.

6. Justiervorrichtung nach Anspruch 4 oder 5,
**dadurch gekennzeichnet, dass**
der Faden (FA) im Innern der als Druckfeder (DF) ausgelegten Spiralfeder verläuft.

7. Justiervorrichtung nach einem der Ansprüche 1 bis 6,
**dadurch gekennzeichnet, dass**
der Faden (FA) zwei- oder mehrfach umgelenkt im Fadenjustierelement (FJE) verläuft.

8. Justiervorrichtung nach einem der Ansprüche 1 bis 7,
**dadurch gekennzeichnet, dass**
der Faden (FA) stoff- oder formschlüssig mit dem Objekt (OB) verbunden ist.

9. Justiervorrichtung nach einem der Ansprüche 1 bis 8,
**dadurch gekennzeichnet, dass**
der Faden (FA) als Stahlseil oder -litze, Kunststoffschnur oder als geflochtene Kunststoffkordel ausgebildet ist.

10. Justiervorrichtung nach einem der Ansprüche 1 bis 9,
**dadurch gekennzeichnet, dass**
in Reihe zum Fadenjustierelement (FJE) ein feststellbares oder reibungsbehaftetes Axiallager vorgesehen ist.

11. Justiervorrichtung nach einem der Ansprüche 1 bis 10,
**dadurch gekennzeichnet, dass**
der Faden (FA) unterbrochen ist und an der Unterbrechungsstelle der Antrieb (AN) in den Faden (FA) integriert ist.

12. Justiervorrichtung nach einem der Ansprüche 1 bis 11,
**dadurch gekennzeichnet, dass**
der Antrieb (AN) als manuell zu verstellende Justierschraube (JS) oder Stimmwirbel ausgebildet ist

13. Justiervorrichtung nach einem der Ansprüche 1 bis 11,
**dadurch gekennzeichnet, dass**
der Antrieb als thermisch längenänderbares System ausgebildet ist.

14. Justiervorrichtung nach einem der Ansprüche 1 bis 11,
**dadurch gekennzeichnet, dass**
der Antrieb als piezoelektrisch oder motorisch angetriebenes System ausgebildet ist.

15. Justiervorrichtung nach Anspruch 14,
**dadurch gekennzeichnet, dass**
das motorisch angetriebene System ein Linearmotor (LM) ist.

16. Justiervorrichtung nach einem der Ansprüche 1 bis 15,
**dadurch gekennzeichnet, dass**
mehrere Fadenjustierelemente (FJE) auf den Achsen des kartesischen Koordinatensystems angeordnet sind.

17. Justiervorrichtung nach Anspruch 16,
**dadurch gekennzeichnet, dass**
mehrere Fadenjustierelemente (FJE) parallel zu einer Achse des kartesischen Koordinatensystems angeordnet sind.

18. Justiervorrichtung nach Anspruch 17,
**dadurch gekennzeichnet, dass**
sechs Fadenjustierelemente (FJE) in der Form eines Hexapods oder kartesischen Sechsstablagers angeordnet sind.

19. Justiervorrichtung nach einem der Ansprüche 16 bis 18,
**dadurch gekennzeichnet, dass**
die Fäden (FA) mehrerer Fadenjustierelemente (FJE) mittels eines gemeinsamen Antriebs (AN) verlängert oder verkürzt werden.

20. Justiervorrichtung nach Anspruch 19,
**dadurch gekennzeichnet, dass**
der gemeinsame Antrieb (AN) einen Justierstock oder eine Wickeltrommel aufweist.

21. Justiervorrichtung nach einem der Ansprüche 1 bis 20,
**dadurch gekennzeichnet, dass**
der Faden (FA) durch eine Düse hindurchgeführt ist, deren Austrittsöffnung einen unteren Gelenkpunkt (GP) des Fadenjustierelements (FJE) zur Basis (BA) definiert.

22. Justiervorrichtung nach einem der Ansprüche 1 bis 20,
**dadurch gekennzeichnet, dass**
der Faden (FA) über eine Umlenkrolle geführt ist, deren Ablauffläche einen unteren Gelenkpunkt (GP) des Fadenjustierelements (FJE) zur Basis (BA) definiert.

## Claims

1. Adjusting device for high-precision positioning of an object with respect to a base by means of at least one solid-state articulation firmly connected to the object, the displacement of which solid-state articulation with respect to the base is adjustable by means of a drive, **characterised in that** the solid-state articulation is in the form of a thread adjusting element (FJE) and includes a twistable thread (FA) which is firmly connected to the object (OB) and is pretensioned with respect to the latter by a tensioning element (SE), and a longitudinal displacement of the thread adjusting element (FJE) is effected by a displacement of a fastening point (BP) of the thread (FA) to a linear drive (AN) firmly connected to the base (BA) by adjustment of said linear drive (AN), the displacement and the free length of the thread (FA) determining the distance between the object (OB) and the base (BA).

2. Adjusting device according to Claim 1, **characterised in that** a single tensioning element (SE) is arranged centrally between the object (OB) and the base (BA).

3. Adjusting device according to Claim 1, **characterised in that** a tensioning element (SE) is associated with each thread adjusting element (FJE) and the thread (FA) is arranged in parallel to the tensioning element (SE) which is configured for compression, or in series with the tensioning element (SE) which is configured for tension.

4. Adjusting device according to any one of Claims 1 to 3, **characterised in that** the tensioning element (SE) is in the form of a helical spring.

5. Adjusting device according to Claim 4, **characterised in that** in its central region the helical spring is surrounded by a sleeve or is replaced thereby.

6. Adjusting device according to Claim 4 or 5, **characterised in that** the thread (FA) is disposed inside the helical spring configured as a compression spring (DF).

7. Adjusting device according to any one of Claims 1 to 6, **characterised in that** the thread (FA) is deflected two or more times in the thread adjusting element (FJE).

8. Adjusting device according to any one of Claims 1 to 7, **characterised in that** the thread (FA) is connected by a material or form-fitting joint to the object (OB).

9. Adjusting device according to any one of Claims 1 to 8, **characterised in that** the thread (FA) is in the form of a steel cable or cord, a plastics string or a braided plastics twine.

10. Adjusting device according to any one of Claims 1 to 9, **characterised in that** an axial bearing which is lockable or is subjected to the influence of friction is provided in series with the thread adjusting element (FJE).

11. Adjusting device according to any one of Claims 1 to 10, **characterised in that** the thread (FA) is interrupted and the drive (AN) is integrated in the thread (FA) at the interruption location.

12. Adjusting device according to any one of Claims 1 to 11, **characterised in that** the drive (AN) is in the form of a manually adjustable adjusting screw (JS) or tuning peg.

13. Adjusting device according to any one of Claims 1 to 11, **characterised in that** the drive is in the form of a thermal length-changing system.

14. Adjusting device according to any one of Claims 1 to 11, **characterised in that** the drive is in the form of a piezoelectrically-driven or motor-driven system.

15. Adjusting device according to Claim 14, **characterised in that** the motor-driven system is a linear motor (LM).

16. Adjusting device according to any one of Claims 1 to 15, **characterised in that** a plurality of thread adjusting elements (FJE) are arranged on the axes of the cartesian coordinate system.

17. Adjusting device according to Claim 16, **characterised in that** a plurality thread adjusting elements (FJE) are arranged parallel to an axis of the cartesian coordinate system.

18. Adjusting device according to Claim 17, **characterised in that** six thread adjusting elements (FJE) are arranged in the form of a hexapod or a cartesian six-bar support.

19. Adjusting device according to any one of Claims 16 to 18, **characterised in that** the threads (FA) of a plurality of thread adjusting elements (FJE) are lengthened or shortened by means of a common drive (AN).

20. Adjusting device according to Claim 19, **characterised in that** the common drive (AN) has an adjusting bar or a winding drum.

21. Adjusting device according to any one of Claims 1 to 20, **characterised in that** the thread (FA) is passed through a nozzle, the outlet orifice of which defines a lower articulation point (GP) of the thread adjusting element (FJE) with respect to the base (BA).

22. Adjusting device according to any one of Claims 1 to 20, **characterised in that** the thread (FA) is guided via a deflection roller, the running surface of which defines a lower articulation point (GP) of the thread adjusting element (FJE) with respect to the base (BA).

## Revendications

1. Dispositif d'ajustement pour le positionnement ultra-précis d'un objet par rapport à une base au moyen d'une articulation à corps solide reliée de façon fixe à l'objet et dont l'excursion par rapport à la base est réglable au moyen d'un entraînement,
**caractérisé en ce que**
l'articulation à corps solide est un élément d'ajustement à fil (FJE) et présente un fil rotatif (FA) relié de façon fixe à l'objet (OB) et précontraint par rapport à celui-ci par un élément de serrage (SE), et une excursion longitudinale de l'élément d'ajustement à fil (FJE) s'effectue par un déplacement d'un point de fixation (BP) du fil (FA) sur un entraînement linéaire (AN) relié de façon fixe à la base (BA) par le réglage de celui-ci, sachant que le déplacement et la longueur libre du fil (FA) détermine la distance entre l'objet (OB) et la base (BA).

2. Dispositif d'ajustement selon la revendication 1,
**caractérisé en ce qu'**
un seul élément de serrage (SE) est disposé au centre entre l'objet (OB) et la base (BA).

3. Dispositif d'ajustement selon la revendication 1,
**caractérisé en ce qu'**
un élément de serrage (SE) est associé à chaque élément d'ajustement à fil (FJE), et le fil (FA) est parallèle à l'élément de serrage (SE) actionné par pression, ou en série avec l'élément de serrage (SE) actionné par traction.

4. Dispositif d'ajustement selon l'une des revendications 1 à 3,
**caractérisé en ce que**
l'élément de serrage (SE) est un ressort en spirale.

5. Dispositif d'ajustement selon la revendication 4,
**caractérisé en ce que**
la zone centrale du ressort en spirale est entourée par une douille ou remplacée par celle-ci.

6. Dispositif d'ajustement selon la revendication 4 ou 5,
**caractérisé en ce que**
le fil (FA) s'étend à l'intérieur du ressort en spirale conçu sous forme de ressort à pression (DF).

7. Dispositif d'ajustement selon l'une des revendications 1 à 6,
**caractérisé en ce que**
le fil (FA) s'étend dans l'élément d'ajustement à fil (FJE) dévié deux ou plusieurs fois.

8. Dispositif d'ajustement selon l'une des revendications 1 à 7,
**caractérisé en ce que**
le fil (FA) est relié à l'objet (OB) par complémentarité de matière ou de forme.

9. Dispositif d'ajustement selon l'une des revendications 1 à 8,
**caractérisé en ce que**
le fil (FA) est un câble ou un toron en acier, un fil en matière plastique ou un cordon tressé en matière plastique.

10. Dispositif d'ajustement selon l'une des revendications 1 à 9,
**caractérisé en ce qu'**
un palier axial à caler ou sollicité par frottement est prévu en série avec l'élément d'ajustement à fil (FJE).

11. Dispositif d'ajustement selon l'une des revendications 1 à 10,
**caractérisé en ce que**
le fil (FA) est interrompu et l'entraînement (AN) est intégré dans le fil (FA) au niveau du point de l'interruption.

12. Dispositif d'ajustement selon l'une des revendications 1 à 11,
**caractérisé en ce que**
l'entraînement (AN) est une vis micrométrique de réglage (JS) réglable manuellement ou une cheville de réglage.

13. Dispositif d'ajustement selon l'une des revendications 1 à 11,
**caractérisé en ce que**
l'entraînement est un système thermiquement variable en longueur.

14. Dispositif d'ajustement selon l'une des revendications 1 à 11,
**caractérisé en ce que**
l'entraînement est un système à entraînement piézoélectrique ou motorisé.

15. Dispositif d'ajustement selon la revendication 14,
**caractérisé en ce que**
le système à entraînement motorisé est un moteur linéaire (LM).

16. Dispositif d'ajustement selon l'une des revendications 1 à 15,
**caractérisé en ce que**
plusieurs éléments d'ajustement à fil (FJE) sont disposés sur les axes du système de coordonnées cartésiennes.

17. Dispositif d'ajustement selon la revendication 16,
**caractérisé en ce que**
plusieurs éléments d'ajustement à fil (FJE) sont disposés parallèlement à un axe du système de coordonnées cartésiennes.

18. Dispositif d'ajustement selon la revendication 17,
**caractérisé en ce que**
six éléments d'ajustement à fil (FJE) sont disposés en forme d'hexapode ou de palier à tige hexagonale cartésien.

19. Dispositif d'ajustement selon l'une des revendications 16 à 18,
**caractérisé en ce que**
les fils (FA) de plusieurs éléments d'ajustement à fil (FJE) sont rallongés ou raccourcis au moyen d'un entraînement (AN) commun.

20. Dispositif d'ajustement selon la revendication 19,
**caractérisé en ce que**
l'entraînement (AN) commun présente un listel d'ajustement ou un tambour enrouleur.

21. Dispositif d'ajustement selon l'une des revendications 1 à 20,
**caractérisé en ce que**
le fil (FA) traverse une buse dont l'ouverture de sortie définit un point d'articulation bas (GP) de l'élément d'ajustement à fil (FJE) par rapport à la base (BA).

22. Dispositif d'ajustement selon l'une des revendications 1 à 20,
**caractérisé en ce que**
le fil (FA) passe sur une poulie de renvoi dont la surface de déroulement définit un point d'articulation bas (GP) de l'élément d'ajustement à fil (FJE) par rapport à la base (BA).
